(19) Europäisches Patentamt
European Patent Office
Office européen des brevets

(11) **EP 4 325 578 A1**

(12) **EUROPÄISCHE PATENTANMELDUNG**

(43) Veröffentlichungstag:
**21.02.2024 Patentblatt 2024/08**

(21) Anmeldenummer: **23184963.9**

(22) Anmeldetag: **12.07.2023**

(51) Internationale Patentklassifikation (IPC):
*H01L 29/06* (2006.01)     *H01L 29/08* (2006.01)
*H01L 29/417* (2006.01)     *H01L 29/74* (2006.01)

(52) Gemeinsame Patentklassifikation (CPC):
**H01L 29/41716; H01L 29/0692; H01L 29/0839;
H01L 29/74**

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**KH MA MD TN**

(30) Priorität: **16.08.2022 DE 102022120612**

(71) Anmelder: **Infineon Technologies Bipolar GmbH
& Co. KG
59581 Warstein (DE)**

(72) Erfinder:
• DROLDNER, Markus
  **59229 Ahlen (DE)**
• DRILLING, Christof
  **59955 Winterberg (DE)**
• KELLNER-WERDEHAUSEN, Uwe
  **91359 Leutenbach (DE)**
• SOMMER, Sebastian Paul
  **44579 Castrop-Rauxel (DE)**
• STELTE, Michael
  **33178 Borchen (DE)**

(74) Vertreter: **Westphal, Mussgnug & Partner,
Patentanwälte mbB
Werinherstraße 79
81541 München (DE)**

(54) **HALBLEITERBAUELEMENT**

(57) Ein Halbleiterbauelement weist einen Halbleiterkörper (100) der eine erste Oberfläche (101) und eine der ersten Oberfläche (101) in vertikaler Richtung (y) gegenüberliegende zweite Oberfläche (102), einen Gatebereich (210), und einen in horizontaler Richtung benachbart zu dem Gatebereich (210) angeordneten aktiven Bereich (220) aufweist. Ein erster Emitter (20) eines ersten Leitungstyps, eine erste Basis (22) eines zweiten Leitungstyps und eine zweite Basis (24) des ersten Leitungstyps sind zwischen der zweiten Oberfläche (102) und der ersten Oberfläche (101) in vertikaler Richtung (y) aufeinanderfolgend angeordnet. Das Halbleiterbauelement weist weiterhin einen in dem aktiven Bereich (220) angeordneten vorderseitigen Emitter (30) des zweiten Leitungstyps, der sich von der ersten Oberfläche (101) in vertikaler Richtung (y) in die zweite Basis (24) erstreckt, und eine Vielzahl von Kurzschlussgebieten (32) des ersten Leitungstyps auf, die sich von der ersten Oberfläche (101) durch den vorderseitigen Emitter (30) hindurch bis zu der zweiten Basis (24) erstrecken, wobei der aktive Bereich (220) einen an den Gatebereich (210) in horizontaler Richtung angrenzenden ersten Randbereich (310), einen an den ersten Randbereich (310) in horizontaler Richtung angrenzenden Ausfallbereich (320), und einen an den Ausfallbereich (320) in horizontaler Richtung angrenzenden zweiten Randbereich (330) aufweist, und eine mittlere Dichte der in dem Ausfallbereich (320) angeordneten Kurzschlussgebiete (32) geringer ist als eine mittlere Dichte der jeweils in dem ersten Randbereich (310) und dem zweiten Randbereich (330) angeordneten Kurzschlussgebiete (32).

FIG 4

**Beschreibung**

Die vorliegende Erfindung betrifft ein Halbleiterbauelement, insbesondere ein Halbleiterbauelement zum Schutz eines Umrichters im Falle eines Störfalls.

Leistungshalbleitermodule wie beispielsweise IGBT-Module (IGBT = Insulated Gate Bipolar Transistor) weisen in der Regel eine oder mehrere Freilaufdioden auf. Als Freilaufdioden werden dabei immer häufiger Siliziumkarbid (SiC) Dioden eingesetzt. Dadurch kann die Leistungsdichte beispielsweise in Umrichtern zur Verwendung in Photovoltaik- oder Windkraftanlagen deutlich gesteigert werden. Die Freilaufdioden, insbesondere Siliziumkarbid-Dioden, sind jedoch nur in geringem Maße überlastfähig. Im Fehlerfall kann ein sehr hoher Kurzschlussstrom auftreten, welcher zur Explosion der Freilaufdioden führen kann, wodurch hochleitfähiges Plasma austreten kann, welches zu weiteren Folgekurzschlüssen im Umrichter führen kann. Dies kann zum Brand einer entsprechenden Anlage und letztendlich zu einem Totalausfall führen.

Leistungshalbleitermodule weisen daher häufig mechanische Schutzelemente wie z.B. magnetische Leistungsschalter oder Schmelzleiter auf, durch welche das Modul im Falle eines Kurzschlusses abgeschaltet wird. Derartige Schutzelemente sind jedoch mit Schaltzeiten um die $500\mu s$ verhältnismäßig langsam und können ein Modul im Fehlerfall daher nicht immer rechtzeitig abschalten, so dass Schäden am Modul nicht zuverlässig verhindert werden können. Deutlich schnellere Schaltzeiten (z.B. $<20\mu s$) können mit Halbleiterbauelementen erreicht werden, welche im Fehlerfall das Netz definiert kurzschließen, wodurch das Leistungshalbleitermodul zuverlässig und rechtzeitig abgeschaltet und durch Fehlerströme verursachte Schäden am Leistungshalbleitermodul vermieden werden. Durch die im Fehlerfall auftretenden hohen Fehlerströme kann sich in derartigen Halbleiterbauelementen jedoch ein Plasma bilden, welches zu Fehlern oder sogar Ausfällen des Leistungshalbleitermoduls führen kann, wenn dieses ungewollt aus dem Halbleiterbauelement austritt und umliegende Bauelemente beschädigt oder zerstört.

Die Aufgabe besteht somit darin, ein schnell schaltendes Halbleiterbauelement bereitzustellen, welches im Falle einer Störung einen auftretenden hohen Fehlerstrom abfangen und ein Modul rechtzeitig abschalten kann, ohne dass ungewollt Plasma aus dem Halbleiterbauelement austritt, so dass Schäden am Modul zuverlässig verhindert werden können.

Ein Halbleiterbauelement weist einen Halbleiterkörper, der eine erste Oberfläche und eine der ersten Oberfläche in vertikaler Richtung gegenüberliegende zweite Oberfläche, einen Gatebereich, und einen in horizontaler Richtung benachbart zu dem Gatebereich angeordneten aktiven Bereich aufweist. Ein erster Emitter eines ersten Leitungstyps, eine erste Basis eines zweiten Leitungstyps und eine zweite Basis des ersten Leitungstyps sind zwischen der zweiten Oberfläche und der ersten Oberfläche in vertikaler Richtung aufeinanderfolgend angeordnet. Das Halbleiterbauelement weist weiterhin einen in dem aktiven Bereich angeordneten vorderseitigen Emitter des zweiten Leitungstyps, der sich von der ersten Oberfläche in vertikaler Richtung in die zweite Basis erstreckt, und eine Vielzahl von Kurzschlussgebieten des ersten Leitungstyps auf, die sich von der ersten Oberfläche durch den vorderseitigen Emitter hindurch bis zu der zweiten Basis erstrecken, wobei der aktive Bereich einen an den Gatebereich in horizontaler Richtung angrenzenden ersten Randbereich, einen an den ersten Randbereich in horizontaler Richtung angrenzenden Ausfallbereich, und einen an den Ausfallbereich in horizontaler Richtung angrenzenden zweiten Randbereich aufweist, und eine mittlere Dichte der in dem Ausfallbereich angeordneten Kurzschlussgebiete geringer ist als eine mittlere Dichte der jeweils in dem ersten Randbereich und dem zweiten Randbereich angeordneten Kurzschlussgebiete.

Die Erfindung wird nachfolgend anhand von Beispielen und unter Bezugnahme auf die Figuren näher erläutert. Dabei bezeichnen gleiche Bezugszeichen gleiche Elemente. Die Darstellung in den Figuren ist nicht maßstäblich.

Figur 1 zeigt schematisch einen Querschnitt durch ein Halbleiterbauelement;

Figur 2 zeigt beispielhaft eine Draufsicht auf das Halbleiterbauelement aus Figur 1;

Figur 3 zeigt beispielhaft eine Draufsicht auf ein Halbleiterbauelement gemäß einem anderen Beispiel;

Figur 4 zeigt schematisch einen Querschnitt durch ein Halbleiterbauelement gemäß einem Beispiel;

Figur 5 zeigt schematisch eine Draufsicht auf die Emitterstruktur des Halbleiterbauelements aus Figur 4;

Figur 6 zeigt schematisch eine Anordnung von Kurzschlussgebieten gemäß einem Beispiel;

Figur 7 zeigt schematisch eine Anordnung von Kurzschlussgebieten gemäß einem weiteren Beispiel;

Figur 8 zeigt schematisch einen Ausschnitt der Anordnung aus Figur 7;

Figur 9 zeigt schematisch einen Querschnitt durch ein Halbleiterbauelement gemäß einem weiteren Beispiel;

Figur 10 zeigt schematisch einen Querschnitt durch ein Halbleiterbauelement gemäß einem weiteren Beispiel; und

Figur 11 zeigt schematisch einen Querschnitt durch ein Halbleiterbauelement gemäß einem weiteren Beispiel.

In der nachfolgenden ausführlichen Beschreibung wird anhand konkreter Beispiele veranschaulicht, wie die Erfindung realisiert werden kann. Es versteht sich, dass die Merkmale der verschiedenen hierin beschriebenen Beispiele, sofern nicht anderweitig erwähnt, miteinander kombiniert werden können. Sofern bestimmte Elemente als "erstes Element", "zweites Element",... oder dergleichen bezeichnet werden, dient die Angabe "erstes", "zweites",... lediglich dazu, verschiedene Elemente voneinander zu unterscheiden. Eine Reihenfolge oder Aufzählung ist mit dieser Angabe nicht verbunden. Das bedeutet, dass beispielsweise ein "zweites Element" auch dann vorhanden sein kann, wenn kein "erstes Element" vorhanden ist.

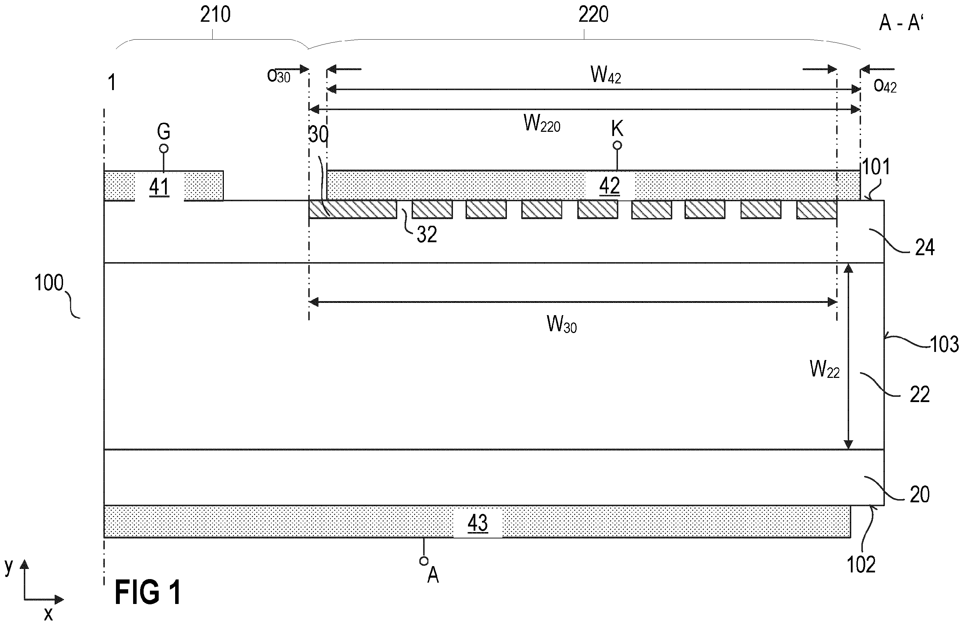

Figur 1 zeigt schematisch einen Querschnitt durch ein Halbleiterbauelement. Das Halbleiterbauelement weist einen Halbleiterkörper 100 auf, wobei der Halbleiterkörper 100 eine erste Oberfläche 101 und eine der ersten Oberfläche 101 in vertikaler Richtung y gegenüberliegende zweite Oberfläche 102 aufweist. Der Halbleiterkörper 100 kann ein herkömmliches Halbleitermaterial wie beispielsweise Silizium (Si), Siliziumkarbid (SiC), Galliumnitrid (GaN), Galliumarsenid (GaAs), oder ähnliches aufweisen.

Eine Thyristor-artige Struktur ist in dem Halbleiterkörper 100 gebildet, wobei in Figur 1 nur ein Teil der Thyristor-artigen Struktur dargestellt ist. Insbesondere sind in vertikaler Richtung y zwischen der zweiten Oberfläche 102 und der ersten Oberfläche 101 nacheinander ein p-dotierter Emitter 20 (erster Emitter eines ersten Leitungstyps), eine n-dotierte Basis 22 (erste Basis eines zweiten Leitungstyps) und eine p-dotierte Basis 24 (zweite Basis des ersten Leitungstyps) angeordnet. Das heißt, der p-dotierte Emitter 20 erstreckt sich von der zweiten Oberfläche 102 in vertikaler Richtung y in den Halbleiterkörper 100 hinein, und die p-dotierte Basis 24 erstreckt sich von der ersten Oberfläche 101 in Richtung des p-dotierten Emitters 20 in den Halbleiterkörper 100 hinein. Die n-dotierte Basis 22 ist in vertikaler Richtung y zwischen dem p-dotierten Emitter 20 und der p-dotierten Basis 24 angeordnet und trennt diese voneinander.

Anstelle eines p-dotierten Emitters 20, einer n-dotierten Basis 22 und einer p-dotierten Basis (so genannte npnp-Struktur), könnten auch ein n-dotierter Emitter 20, eine p-dotierte Basis und eine n-dotierte Basis 24 in vertikaler Richtung y zwischen der zweiten Oberfläche 102 und der ersten Oberfläche 101 nacheinander angeordnet sein (so genannte pnpn-Struktur). Die im Weiteren anhand einer npnp-Struktur beschriebenen Grundsätze können ohne weiteres auch auf eine pnpn-Struktur übertragen werden.

Der Halbleiterkörper 100 weist einen Gatebereich 210, und einen in horizontaler Richtung x benachbart zu dem Gatebereich 210 angeordneten aktiven Bereich 220 auf. In dem aktiven Bereich 220 ist ein n-dotierter vorderseitiger Emitter 30 angeordnet, der sich von der ersten Oberfläche 101 in vertikaler Richtung y in die p-dotierte Basis 24 hinein erstreckt. Im Fall einer pnpn-Struktur ist in dem aktiven Bereich 220 ein p-dotierter vorderseitiger Emitter 30 angeordnet, der sich von der ersten Oberfläche 101 in vertikaler Richtung y in die n-dotierte Basis 24 hinein erstreckt. Der n-dotierte vorderseitige Emitter 30 erstreckt sich dabei jedoch nur teilweise in die p-dotierte Basis 24 hinein, so dass eine Schicht der p-dotierten Basis 24 zwischen dem n-dotierten vorderseitigen Emitter 30 und der n-dotierten Basis 22 angeordnet ist und der n-dotierte vorderseitige Emitter 30 durch diese Schicht der p-dotierten Basis 24 von der n-dotierten Basis 22 getrennt ist. Der n-dotierte vorderseitige Emitter 30 weist in horizontaler Richtung x eine Breite $W_{30}$ auf. Diese Breite $W_{30}$ wird oft auch als Emitterweite bezeichnet.

Eine Vielzahl von komplementär zu dem n-dotierten vorderseitigen Emitter 30 dotierten Kurzschlussgebiete 32 erstreckt sich von der ersten Oberfläche 101 durch den n-dotierten vorderseitigen Emitter 30 hindurch bis zu der p-dotierten Basis 24. Mittels dieser Kurzschlussgebiete 32 kann die p-dotierte Basis 24 elektrisch direkt an eine auf der ersten Oberfläche 101 angeordnete Kathoden-Elektrode 42 angeschlossen werden. Die Kathoden-Elektrode 42 kann einen Kathodenanschluss K bilden oder mit einem Kathodenanschluss K elektrisch verbunden sein. Die Kathoden-Elektrode 42 ist dabei auf der ersten Oberfläche 101 im Wesentlichen in Bereichen oberhalb des vorderseitigen Emitters 30 angeordnet. Das heißt, die Kathoden-Elektrode 42 ist im aktiven Bereich 220, nicht jedoch im Gatebereich 210 angeordnet.

Die Kathoden-Elektrode 42 weist in horizontaler Richtung x eine Breite $W_{42}$ auf. In horizontaler Richtung x erstreckt sich der vorderseitige Emitter 30 weiter zu dem Gatebereich 210 hin als die Kathoden-Elektrode 42. Das heißt, der vorderseitige Emitter 30 ist hier nicht vollständig von der Kathoden-Elektrode 42 bedeckt. Der Bereich des vorderseitigen Emitters 30, welcher nicht von der Kathoden-Elektrode 42 bedeckt wird (Abstand $o_{30}$ zwischen einer ersten Kante des vorderseitigen Emitters 30 und einer ersten Kante der Kathoden-Elektrode 42), kann in horizontaler Richtung x eine Breite $o_{30}$ von beispielsweise 0,1 bis 0,5mm haben. Während in Richtung des Gatebereiches 210 der vorderseitige Emitter 30 über die Kathoden-Elektrode 42 hinaus ragt, ragt die Kathoden-Elektrode 42 auf ihrer dem Gatebereich 210 abgewandten Seite über den vorderseitigen Emitter 30 hinaus. Ein Abstand $o_{42}$ zwischen einer zweiten Kante der Kathoden-Elektrode 42 und einer zweiten Kante des vorderseitigen Emitters 30 in horizontaler Richtung x kann beispielsweise bis zu 1cm betragen. Der Abstand $o_{42}$ zwischen einer zweiten Kante der Kathoden-Elektrode 42 und einer zweiten Kante des vorderseitigen Emitters 30 kann beispielsweise größer sein als der Abstand $o_{30}$ zwischen der ersten Kante des vorderseitigen Emitters 30 und der ersten Kante der Kathoden-Elektrode 42. Dabei ist die erste Kante der Kathoden-Elektrode 42 eine dem Gatebereich 210 zugewandte Kante, und die zweite Kante der Kathoden-Elektrode 42 ist eine dem Gatebereich 210 abgewandte Kante. Die erste Kante des vorderseitigen Emitters 30 ist eine dem Gatebereich 210 zugewandte Kante, und die zweite Kante des vorderseitigen Emitters 30 ist eine dem Gatebereich 210 abgewandte Seite.

In dem Gatebereich 210 ist auf der ersten Oberfläche 101 eine Gate-Elektrode 41 angeordnet. Die Gate-Elektrode 41 kann einen Gateanschluss G bilden oder mit einem Gateanschluss G elektrisch verbunden sein. Die Gate-Elektrode 41 ist in horizontaler Richtung x beabstandet von der Kathoden-Elektrode 42 angeordnet. Das heißt, es besteht keine direkte elektrische Verbindung zwischen der Gate-Elektrode 41 und der Kathoden-Elektrode 42.

Eine Anoden-Elektrode 43 ist auf der zweiten Oberfläche 102 des Halbleiterkörpers 100 angeordnet. Die Anoden-Elektrode 43 kann dabei die zweite Oberfläche 102 vollständig oder fast vollständig bedecken. Das heißt, die Anoden-Elektrode 43 ist sowohl im Gatebereich 210 als auch im aktiven Bereich 220 angeordnet. Die Anoden-Elektrode 43 kann einen Anodenanschluss A bilden oder mit einem Anodenanschluss A verbunden sein.

Die Gate-Elektrode 41 kann eine Zündstruktur des Thyristor-artigen Bauelements bilden. Der n-dotierte vorderseitige Emitter 30, die p-dotierte Basis 24, die n-dotierte Basis 22 und der p-dotierte Emitter 20 bilden eine selbstsperrende npnp-Struktur. Das heißt, im Normalzustand (Gate-Strom = Null) sperrt das Halbleiterbauelement bei beiden möglichen Polaritäten. Durch ein an der Gate-Elektrode 41 angelegtes Zünd- oder Einschaltsignal (z.B. positiver Gate-Strom größer Null von der Gate-Elektrode 41 zur Kathoden-Elektrode 42) kann eine elektrisch leitende, niederohmige Verbindung zwischen der Kathoden-Elektrode 42 und der Anoden-Elektrode 43 hergestellt werden, wobei die Anoden-Elektrode 43 mit einem ersten Potential verbunden ist, die Kathoden-Elektrode 42 mit einem zweiten Potential verbunden ist, und das erste Potential positiv ist gegenüber dem zweiten Potential (positive Spannung zwischen Anoden-Elektrode 43 und Kathoden-Elektrode 42). Beim Einschalten (Zünden) des Halbleiterbauelements bildet sich ein Stromplasma, welches sich ausgehend von einer dem Gatebereich 210 zugewandten Seite des n-dotierten vorderseitigen Emitters 30 über den gesamten aktiven Bereich 220 ausbreitet, bis der gesamte aktive Bereich 220 den Strom führt und zwischen der Kathoden-Elektrode 42 und der Anoden-Elektrode 43 ein hoher Laststrom fließt. Eine anliegende Durchlassspannung nimmt in diesem leitenden Zustand des Halbleiterbauelements ihren kleinsten Wert an. Erst wenn der durch das Halbleiterbauelement fließende Strom wieder auf Null absinkt, wechselt das Halbleiterbauelement wieder in den sperrenden Zustand.

Die Sperr- bzw. Blockierspannung eines solchen Thyristor-artigen Bauelements ergibt sich aus der minimalen Dicke $W_{22}$ und dem spezifischen Widerstand $\rho$ der n-dotierten Basis 22. Die Durchlassverluste (Leitverluste) sowie die Höhe des maximal zulässigen Stromstoßes werden unter anderem durch die minimale Fläche des n-dotierten vorderseitigen Emitters 30 bestimmt. Da das beschriebene Thyristor-artige Halbleiterbauelement im Falle einer Störung einen auftretenden hohen Fehlerstrom abfängt und dadurch zerstört (aufgeschmolzen) wird, spielen Durchlassverluste jedoch keine wesentliche Rolle, da nicht wie bei herkömmlichen Thyristoren eine Vielzahl von Schaltvorgängen erfolgt.

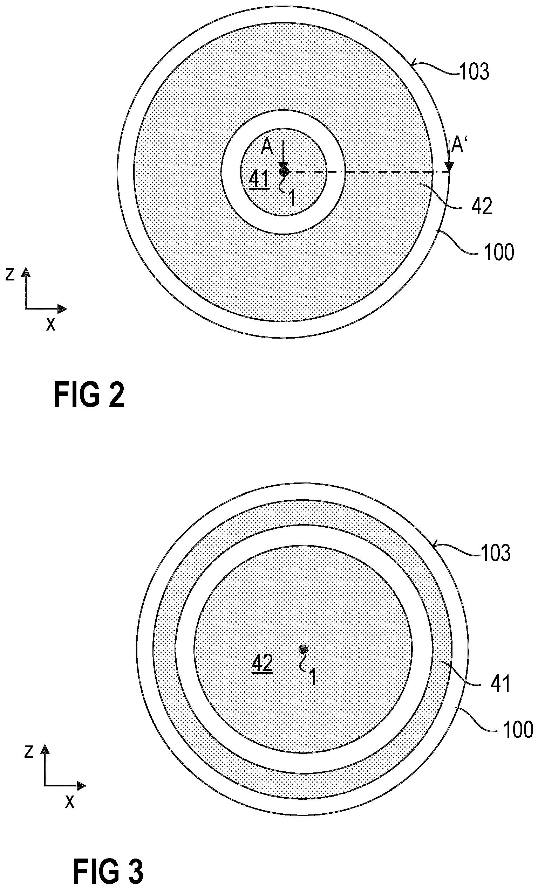

Nun Bezug nehmend auf Figur 2 ist schematisch eine Draufsicht auf ein Halbleiterbauelement gemäß dem Beispiel aus Figur 1 dargestellt. Der Halbleiterkörper 100 weist dabei eine runde Querschnittsfläche auf. Anstelle einer runden Querschnittsfläche sind jedoch auch andere Formen wie beispielsweise eckige Formen (z.B. quadratisch oder rechteckig) grundsätzlich möglich. In dem in Figur 2 dargestellten Beispiel ist der Gate-Bereich 210 in einem zentralen Bereich des Halbleiterkörpers 100 angeordnet und wird in radialer Richtung von dem aktiven Bereich 220 umschlossen. Das heißt, die Gate-Elektrode 41 ist in einem zentralen Bereich des Halbleiterkörpers 100 angeordnet, und die Kathoden-Elektrode 42 bildet einen Ring, welcher die Gate-Elektrode 41 in horizontaler Richtung umgibt. In der Draufsicht in Figur 2 sind lediglich die Gate-Elektrode 41 und die Kathoden-Elektrode 42 sichtbar. Die darunter befindlichen Gebiete sind der Übersichtlichkeit halber nicht explizit dargestellt.

Den Gate-Bereich 210 in einem zentralen Bereich des Halbleiterkörpers 100 anzuordnen ist jedoch nur ein Beispiel. Wie in Figur 3 schematisch dargestellt, ist es ebenfalls möglich den aktiven Bereich 220 in einem zentralen Bereich des Halbleiterkörpers 100 anzuordnen. In diesem Beispiel wird der aktive Bereich 220 (Kathoden-Elektrode 42) in horizontaler Richtung von dem Gate-Bereich 210 (Gate-Elektrode 41) umgeben. Das grundsätzliche Prinzip ist jedoch dasselbe wie oben beschrieben. In beiden Beispielen ist das Halbleiterbauelement rotationssymmetrisch um eine zentrale Achse 1, wobei Figur 1 einen Querschnitt des Halbleiterbauelements aus Figur 2 entlang einer Schnittebene A - A' zeigt. Der Durchmesser eines runden Halbleiterkörpers 100 kann beispielsweise zwischen 15mm und 150mm betragen. Auch größere Durchmesser von bis zu 200mm oder auch mehr sind grundsätzlich möglich.

Eines oder mehrere der beschriebenen Thyristor-artigen Bauelemente können mit einem Leistungshalbleitermodul, wie beispielsweise einem IGBT-Modul (IGBT = Insulated Gate Bipolar Transistor), verbunden sein. Im Falle eines Kurzschlusses kann das Thyristor-artige Bauelement einen auftretenden hohen Fehlerstrom übernehmen. Der Fehlerstrom wird dabei an der Kathoden-Elektrode 42 des Halbleiterbauelements bereitgestellt, so dass das Thyristor-artige Bauelement im Falle eines Fehlerstroms zündet (eingeschaltet wird).

Dabei wird das Halbleiterbauelement insbesondere bei sehr hohen Fehlerströmen oft aufgeschmolzen und zerstört. Das Halbleiterbauelement kann beispielsweise in einer keramischen Kapsel angeordnet sein. Beim Aufschmelzen des Halbleiterbauelementes entsteht durch den Abriss des Kathodenkontakts ein Plasma, welches zu Fehlern oder sogar Ausfällen einer oder mehrerer Komponenten des mit dem Thyristor-artigen Bauelement verbundenen Leistungshalbleitermoduls führen kann, wenn dieses aus dem Halbleiterbauelement, insbesondere aus der keramischen Kapsel, austritt und umliegende Bauelemente beschädigt oder zerstört.

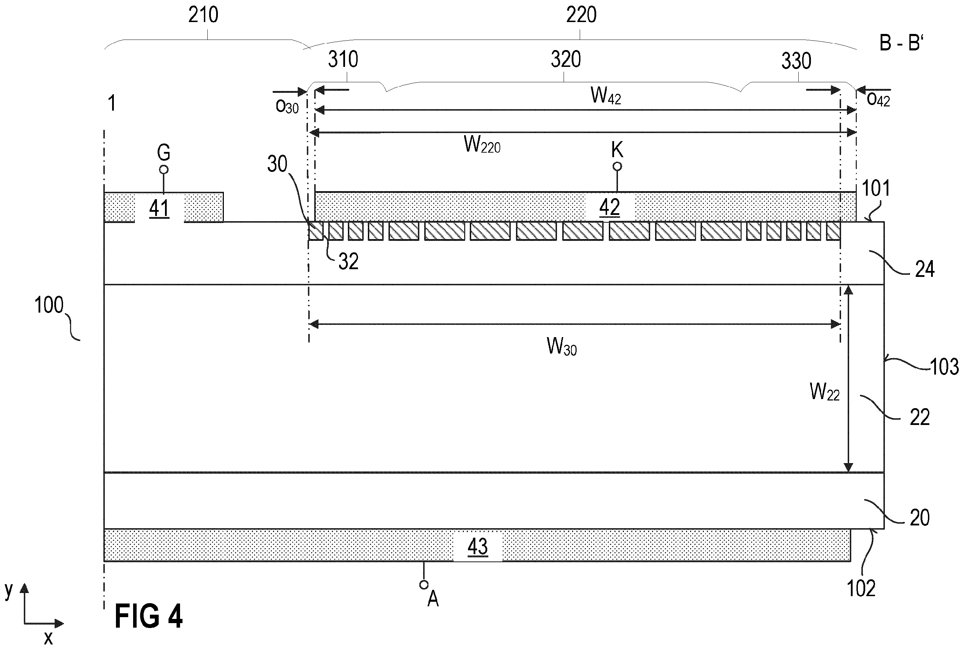

Um ein ungewolltes Austreten von Plasma aus dem Halbleiterbauelement, insbesondere aus der keramischen Kapsel, zu verhindern, weist das in dem in Figur 4 dargestellten Beispiel dargestellte Halbleiterbauelement in seinem aktiven Bereich 220 einen an den Gatebereich 210 in horizontaler Richtung x angrenzenden ersten Randbereich 310, einen an den ersten Randbereich 310 in horizontaler Richtung x angrenzenden Ausfallbereich 320, und einen an den Ausfallbereich 320 in horizontaler Richtung x angrenzenden zweiten Randbereich 330 auf. Der Ausfallbereich 320 ist dabei zwischen dem ersten Randbereich 310 und dem zweiten Randbereich 330 angeordnet. Wie oben in Bezug auf Figur 1 erläutert, weist das Halbleiterbauelement einen in dem aktiven Bereich 220 angeordneten n-dotierten vorderseitigen Emitter 30 auf, der sich von der ersten Oberfläche 101 in vertikaler Richtung y in die p-dotierte Basis 24 hinein erstreckt, wobei sich eine Vielzahl von komplementär zu dem vorderseitigen Emitter 30 dotierten Kurzschlussgebiete 32 von der ersten Oberfläche 101 durch den vorderseitigen Emitter 30 hindurch bis zu der p-dotierten Basis 24 erstreckt.

In dem in Figur 1 dargestellten Halbleiterbauelement ist die Vielzahl von Kurzschlussgebieten 32 gleichmäßig über den gesamten n-dotierten vorderseitigen Emitter 30 verteilt. Das heißt, eine mittlere Dichte der Kurzschlussgebiete 32 ist über die gesamte Fläche des n-dotierten vorderseitigen Emitters 30 gleich. Das heißt, das Querschnittsflächenverhältnis ist über die gesamte Fläche des n-dotierten vorderseitigen Emitters 30 gleich, wobei das Querschnittsflächenverhältnis dem Verhältnis zwischen der Summe der einzelnen Querschnittsflächen aller Kurzschlussgebiete 32 in einem bestimmten Abschnitt des n-dotierten vorderseitigen Emitters 30 und der Querschnittsfläche des entsprechenden Abschnitts des n-dotierten vorderseitigen Emitters 30 entspricht.

Im Gegensatz dazu, ist bei dem in Figur 4 dargestellten Halbleiterbauelement eine mittlere Dichte der in dem Ausfallbereich 320 angeordneten Kurzschlussgebiete 32 geringer als eine mittlere Dichte der jeweils in dem ersten Randbereich 310 und dem zweiten Randbereich 330 angeordneten Kurzschlussgebiete 32. Das heißt, das Querschnittsflächenverhältnis in dem ersten Randbereich 310 und dem zweiten Randbereich 330 ist jeweils größer als das Querschnittsflächenverhältnis in dem Ausfallbereich 320. Die mittlere Dichte der Kurzschlussgebiete 32 (Querschnittsflächenverhältnis) beeinflusst den Laststrom in dem jeweiligen Gebiet und dadurch die Ausbreitungsgeschwindigkeit des sich bildenden Leitungsplasmas. In Gebieten mit hoher mittlerer Dichte der Kurzschlussgebiete 32 (großes Querschnittsflächenverhältnis) ist die Ausbreitungsgeschwindigkeit des Leitungsplasmas geringer (geringere Stromdichte des Anoden-Kathoden-Stroms) als in Gebieten mit niedriger mittlerer Dichte (kleines Querschnittsflächenverhältnis) der Kurzschlussgebiete 32 (höhere Stromdichte des Anoden-Kathoden-Stroms).

Da der Ausfallbereich 320 im Vergleich zu dem ersten Randbereich 310 und dem zweiten Randbereich 330 eine geringere mittlere Dichte der Kurzschlussgebiete 32 aufweist ist dort die Stromdichte des Anoden-Kathoden-Stroms vergleichsweise hoch und die Ausbreitungsgeschwindigkeit des Leitungsplasmas entsprechend höher als in dem ersten Randbereich 310 und dem zweiten Randbereich 330. Das Halbleiterbauelement fällt somit beim Auftreten eines Strompulses an der Gate-Elektrode 41 zuerst in dem Ausfallbereich 320 aus. Das Leitungsplasma breitet sich somit ausgehend von dem Ausfallbereich 320 über den gesamten aktiven Bereich 220 aus. Durch den ersten Randbereich 310, welcher zwischen dem Ausfallbereich 320 und dem Gate-Bereich 210 angeordnet ist, wird eine erhöhte dv/dt-Festigkeit des Halbleiterbauelements erreicht. Um den Gate-Bereich 210 effektiv zu schützen, kann der zwischen dem Ausfallbereich 320 und dem Gate-Bereich 210 angeordnete erste Randbereich 310 beispielsweise eine Breite von zwischen 0,8mm und 1,2mm, z.B. 1mm, aufweisen. Durch den zweiten Randbereich 330 wird zu einer vertikalen Außenfläche 103 des Halbleiterkörpers 100 hin die Stromdichte im Vergleich zum Ausfallbereich 320 reduziert. Der zweite Randbereich 330 kann die gleiche Breite aufweisen wie der erste Randbereich 310. Für einen effektiven Schutz gegen Austreten von Plasma aus dem Halbleiterbauelement kann die Breite des zweiten Randbereiches 330 jedoch auch größer gewählt werden als die Breite des ersten Randbereiches 310, z.B. doppelt so breit. Die Breite des ersten Randbereiches 310 und des zweiten Radbereiches 330 kann beispielsweise in Abhängigkeit vom Durchmesser eines runden Halbleiterkörpers 100 und der Höhe der im Fehlerfall möglicherweise auftretenden Ströme gewählt werden.

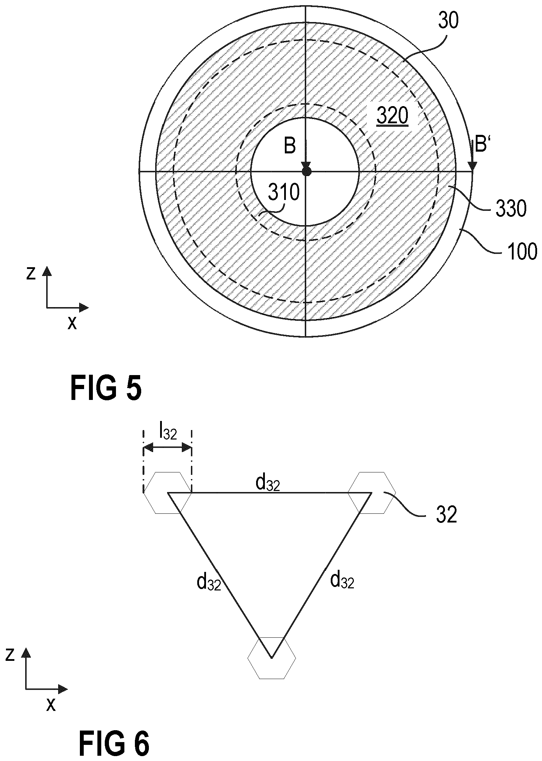

Figur 5 zeigt beispielhaft eine Draufsicht auf ein derartiges Halbleiterbauelement. In der in Figur 5 dargestellten Ansicht wurden dabei die Gate-Elektrode 41 und die Kathoden-Elektrode 42 weggelassen. Figur 5 zeigt somit eine Draufsicht auf die erste Oberfläche 101 wodurch der sich von der ersten Oberfläche 101 in den Halbleiterkörper 100 hinein erstreckende n-dotierte vorderseitige Emitter 30 sichtbar ist. Die Vielzahl von Kurzschlussgebieten 32 ist in der in Figur 5 dargestellten Ansicht nicht explizit dargestellt. Figur 4 zeigt einen Querschnitt des Halbleiterbauelements aus Figur 5 entlang einer Schnittebene B - B'.

Gemäß einem Beispiel ist jedes der Vielzahl von Kurzschlussgebieten 32 säulenartig ausgebildet. Das heißt, jedes der Kurzschlussgebiete 32 weist im Wesentlichen die Form einer Säule auf, welche sich ausgehend von der ersten Oberfläche 101 in vertikaler Richtung y durch den n-dotierten vorderseitigen Emitter 30 hindurch erstreckt. Jedes der Kurzschlussgebiete 32 kann dabei beispielsweise in horizontaler Richtung einen runden, ovalen oder mehreckigen Querschnitt aufweisen.

Figur 6 zeigt beispielhaft in einer Draufsicht lediglich drei einer Vielzahl von säulenartigen Kurzschlussgebieten 32, wobei die Kurzschlussgebiete 32 einen sechseckigen Querschnitt aufweisen. Jedes der Kurzschlussgebiete 32 der Vielzahl von Kurzschlussgebieten 32 sind dabei jeweils an einer Ecke eines gleichseitigen Dreiecks angeordnet. Das heißt, der Abstand $d_{32}$ zwischen zwei direkt benachbarten Kurzschlussgebieten 32 ist jeweils identisch. Eine maximale Ausdehnung $l_{32}$ jedes der Vielzahl von Kurzschlussgebieten 32 kann in horizontaler Richtung x beispielsweise $200\mu$m betragen. Die Form und Größe (Querschnittsfläche) jedes der Vielzahl von Kurzschlussgebieten 32 können dabei identisch sein, unabhängig davon ob ein Kurzschlussgebiet 32 in dem Ausfallbereich 320 oder in dem ersten oder zweiten Randbereich 310, 330 angeordnet ist. In dem ersten Randbereich 310 und dem zweiten Randbereich 330 kann jedoch der Abstand $d_{32}$ zwischen zwei direkt benachbarten Kurzschlussgebieten 32 zwischen $200\mu$m und $800\mu$m betragen, während in dem Ausfallbereich 320 der Abstand $d_{32}$ zwischen zwei direkt benachbarten Kurzschlussgebieten 32 beispielsweise wenigstens $1000\mu$m beträgt. Dadurch kann die mittlere Dichte der Kurzschlussgebiete 32 in jedem der Bereiche 310, 320, 330 entsprechend durch die Wahl eines geeigneten Abstands $d_{32}$ zwischen zwei direkt benachbarten Kurzschlussgebieten 32 eingestellt werden.

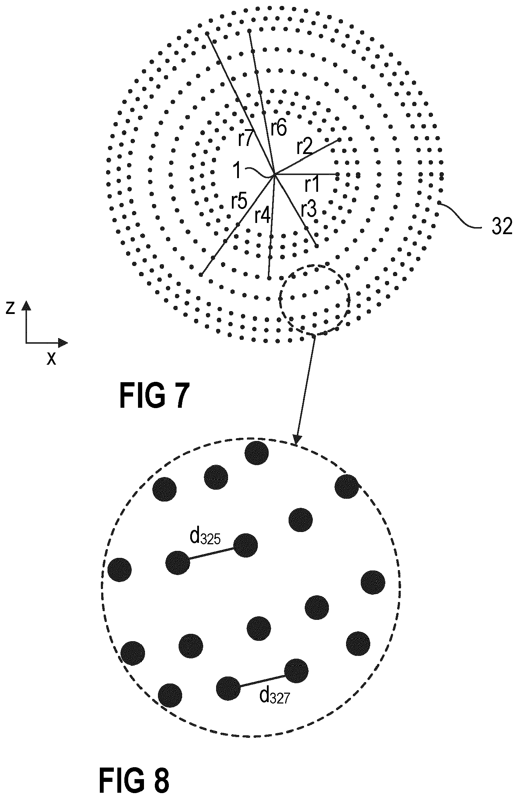

Die Anordnung der Kurzschlussgebiete 32 an den Ecken gleichseitiger Dreiecke, wie in Figur 6 für drei Kurzschlussgebiete 32 beispielhaft dargestellt, ist jedoch nur ein Beispiel. Es ist alternativ ebenfalls möglich die Kurzschlusspunkte 32 in anderen regelmäßigen oder unregelmäßigen Mustern anzuordnen. Ein weiteres mögliches Beispiel ist dabei schematisch in Figur 7 dargestellt. Figur 7 zeigt eine Draufsicht auf eine Vielzahl von Kurzschlussgebieten 32. Andere Elemente des Halbleiterbauelements sind in dieser Ansicht der Einfachheit halber nicht dargestellt. In dem in Figur 7 dargestellten Beispiel sind die Kurzschlusspunkte 32 jeweils entlang eines einer Vielzahl konzentrischer Kreise angeordnet. Jeder der Kreise weist dabei einen unterschiedlichen Radius um die zentrale Achse 1 auf. Eine unterschiedliche mittlere Dichte der Kurzschlusspunkte 32 kann dabei durch eine Variation der Differenz zwischen den Radien zweier benachbarter Kreise erreicht werden. Beispielsweise können ein erster Kreis mit dem Radius r1, ein zweiter Kreis mit dem Radius r2 und ein dritter Kreis mit dem Radius r3 in dem ersten Randbereich 310 angeordnet sein. Ein vierter Kreis mit dem Radius r4 und ein fünfter Kreis mit dem Radius r5 können in dem Ausfallbereich 320 angeordnet sein, und ein sechster Kreis mit dem Radius r6, ein siebter Kreis mit dem Radius r7 (sowie weitere Kreis(e)) können in dem zweiten Randbereich 330 angeordnet sein. Dabei gilt:

$$(r2 - r1) = (r3 - r2) = (r7 - r6) = x$$

$$(r4 - r3) = (r5 - r4) = (r6 - r5) = y$$

wobei x < y. Dabei kann x so gewählt werden, dass kein ungewolltes Zünden des Halbleiterbauelements in dem ersten Randbereich 310 oder dem zweiten Randbereich 330 durch ein hohes dv/dt erfolgt. Das heißt, es kann basierend auf einem maximal möglichen dv/dt eine Obergrenze für x festgelegt werden. Diese Obergrenze hängt jedoch von verschiedenen Faktoren ab und kann für unterschiedliche Halbleiterbauelemente variieren.

Nach diesem Prinzip können in jedem der Bereiche 310, 320, 330 ein oder mehrere Ringe angeordnet sein. Der Abstand $d_{325}$, $d_{327}$ zweier benachbarter Kurzschlussgebiete 32 innerhalb eines Kreises kann für alle Kreise identisch sein. Es ist jedoch auch möglich, alternativ oder zusätzlich den Abstand zweier benachbarter Kurzschlussgebiete 32 entsprechend zu variieren, um die mittlere Dichte der Kurzschlussgebiete 32 in einem Bereich 310, 320, 330 zu verringern oder zu vergrößern.

Figur 8 zeigt beispielhaft einen Ausschnitt aus der Anordnung gemäß Figur 7. Figur 8 zeigt dabei schematisch einen Teil der Kurzschlussgebiete 32 des vierten Kreises (Radius r4), des fünften Kreises (Radius r5), des sechsten Kreises (Radius r6) und des siebten Kreises (Radius r7). Wie oben beschrieben, kann der fünfte Kreis beispielsweise in dem Ausfallbereich 320 angeordnet sein, während der siebte Kreis in dem zweiten Randbereich 330 angeordnet ist. Der Abstand $d_{325}$ zwischen zwei direkt benachbarten Kurzschlussgebieten 32 in dem fünften Kreis kann identisch sein zu dem Abstand $d_{327}$ zwischen zwei direkt benachbarten Kurzschlussgebieten in dem siebten Kreis. Es ist jedoch auch möglich, dass der Abstand $d_{325}$ zwischen zwei direkt benachbarten Kurzschlussgebieten 32 in dem fünften Kreis größer ist als der Abstand $d_{327}$ zwischen zwei direkt benachbarten Kurzschlussgebieten in dem siebten Kreis.

Gemäß einem weiteren Beispiel ist es ebenfalls möglich, dass gilt:

$$(r2 - r1) = (r3 - r2) = (r7 - r6) = x$$

$$(r4 - r3) = (r5 - r4) = (r6 - r5) = y$$

wobei x = y.
In diesem Beispiel kann eine unterschiedliche mittlere Dichte der Kurzschlussgebiete 32 beispielsweise ausschließlich durch einen unterschiedlichen Abstand zwischen zwei direkt benachbarten Kurzschlussgebieten 32 innerhalb der Kreise erreicht werden, wobei der Abstand zwischen zwei direkt benachbarten Kurzschlussgebieten 32 in einem in dem Ausfallbereich 320 angeordneten Kreis größer ist als der Abstand zwischen zwei direkt benachbarten Kurzschlussgebieten 32 in einem in dem ersten Randbereich 310 oder in dem zweiten Randbereich 330 angeordneten Kreis.

Gemäß einem weiteren Beispiel ist es auch möglich, dass in einem oder mehreren der konzentrischen Kreise der Abstand zwischen zwei benachbarten Kurzschlussgebieten 32 Null ist (z.B. $d_{325} = 0$ und/oder $d_{327} = 0$). Dies resultiert in einem oder mehreren ringförmig ausgebildeten Kurzschlussgebieten 32, so dass der vorderseitige Emitter 30 durch das eine oder die mehreren ringförmigen Kurzschlussgebiete 32 in einzelne, konzentrische Ringe geteilt wird (ringförmig ausgebildete Kurzschlussgebiete 32 in den Figuren nicht explizit dargestellt).

Säulenförmige Kurzschlussgebiete 32 und ringförmige Kurzschlussgebiete 32 können dabei auf geeignete Weise miteinander kombiniert werden. Beispielsweise ist es möglich, in dem ersten Randbereich 310 und dem zweiten Randbereich 330 jeweils wenigstens ein ringförmiges Kurzschlussgebiet 32 anzuordnen. In dem Ausfallbereich 320 können beispielsweise ausschließlich säulenförmige Kurzschlussgebiete 32 angeordnet sein. Es ist jedoch ebenfalls möglich, in dem Ausfallbereich 320 ein oder mehrere ringförmige Kurzschlussgebiete 32 anzuordnen. Gemäß einem Beispiel weist ein Halbleiterbauelement ausschließlich ringförmige Kurzschlussgebiete auf.

Eine Breite jedes des einen oder der mehreren ringförmigen Kurzschlussgebiete 32 kann in horizontaler Richtung x beispielsweise maximal 200 $\mu$m oder maximal 500 $\mu$m betragen. Diese Breite kann für alle einer Vielzahl von ringförmigen Kurzschlussgebieten 32 identisch sein, unabhängig davon, ob das ringförmige Kurzschlussgebiet 32 in dem Ausfallbereich 320 oder in einem der ersten oder zweiten Randbereiche 310, 330 angeordnet ist.

In dem ersten Randbereich 310 und dem zweiten Randbereich 330 kann der Abstand zwischen zwei direkt benachbarten ringförmigen Kurzschlussgebieten 32 beispielsweise zwischen 200$\mu$m und 800$\mu$m betragen (z.B. 200$\mu$m < x < 800$\mu$m), während der Abstand zwischen zwei direkt benachbarten Kurzschlussgebieten 32 in dem Ausfallbereich 320 beispielsweise wenigstens 1000$\mu$m betragen kann (z.B. 1000$\mu$m < y). Gemäß einem Beispiel ist in dem Ausfallbereich 320 nur ein einziges ringförmiges Kurzschlussgebiet 32 angeordnet.

Gemäß einem Beispiel beträgt eine Querschnittsfläche des Ausfallbereichs 320 in horizontaler Ebene zwischen 10% und 50% der Gesamtfläche des Halbleiterkörpers 100. Das heißt, der Ausfallbereich 320 kann verhältnismäßig schmal ausgebildet sein, so dass der Bereich hoher Stromdichte im Fall eines Zündens des Halbleiterbauelements verhältnismäßig klein ist. Dadurch kann das Plasma effektiv sowohl von dem Gate-Bereich 210, als auch von der vertikalen Außenfläche 103 des Halbleiterkörpers 100 fern gehalten und ein Austreten des Plasmas aus dem Halbleiterbauelement verhindert werden. Der erste Randbereich 310, welcher benachbart zu dem Gate-Bereich 210 angeordnet ist, mit seiner hohen mittleren Dichte an Kurzschlussgebieten 32 erhöht die Robustheit des Halbleiterbauelements gegenüber hohen Spannungssprüngen (erhöhte dV/dt-Festigkeit des Halbleiterbauelements). Durch eine geeignete Wahl der Größe des Ausfallbereichs 320 kann der minimale Strom, bei welchem das Halbleiterbauelement aufschmilzt geeignet eingestellt werden. Eine kritische Stromdichte, bei welcher es zum Aufschmelzen in dem Ausfallbereich 320 kommt, kann, je nach Auslegung bereits bei verhältnismäßig niedrigem absolutem Strom (z.B. zwischen 1 und 2 kA/cm$^2$) erreicht werden.

Zusätzlich zu der oben beschriebenen verringerten mittleren Dichte der Kurzschlussgebiete 32 im Ausfallbereich 320 kann die Stromdichte im Ausfallbereich 320 noch auf andere Art und Weise weiter erhöht werden. Wie oben in Bezug auf Figur 1 beschrieben, weist ein Halbleiterbauelement in der Regel eine im aktiven Bereich 220 auf der ersten Oberfläche 101 angeordnete und mit dem n-dotierten vorderseitigen Emitter 30 elektrisch verbundene Kathoden-Elektrode 42 auf. Diese wird meist durch eine durchgehende metallische Scheibe oder Schicht gebildet.

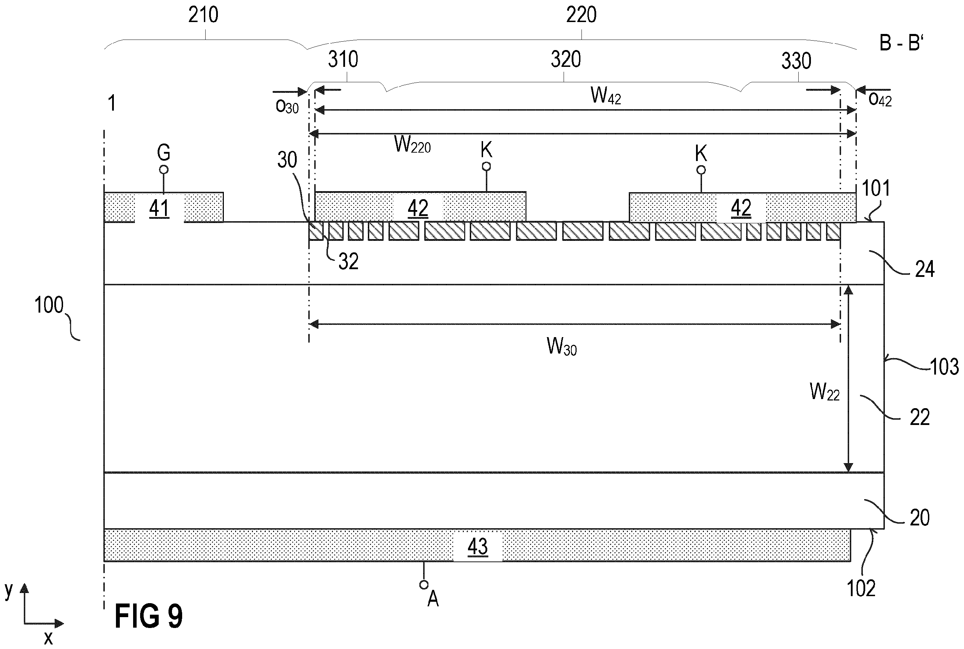

Nun Bezug nehmend auf Figur 9, kann die Kathoden-Elektrode 42 innerhalb des Ausfallbereichs 320 wenigstens eine ringförmige Unterbrechung aufweisen. Wie in den Figuren 2 und 3 dargestellt und wie oben beschrieben, hat die Kathoden-Elektrode 41 bei einem Halbleiterbauelement mit rundem Querschnitt die Form eines Kreises oder eines Ringes. Bei einer ringförmigen Kathoden-Elektrode 42 (vgl. z.B. Figur 2) resultiert eine solche ringförmige Unterbrechung in einem ersten ringförmigen Kathoden-Elektrodenabschnitt und einem davon getrennten zweiten ringförmigen Kathoden-Elektrodenabschnitt. Bei mehr als einer ringförmigen Unterbrechung ergeben sich entsprechend mehr ringförmige Kathoden-Elektrodenabschnitte. Bei einer kreisförmigen Kathoden-Elektrode 42 (vgl. z.B. Figur 3) resultiert eine ringförmige Unterbrechung in einem kreisförmigen ersten Kathoden-Elektrodenabschnitt und einem von diesem getrennten ringförmigen zweiten Kathoden-Elektrodenabschnitt. Bei mehr als einer ringförmigen Unterbrechung ergeben sich ein kreisförmiger erster Kathoden-Elektrodenabschnitt und entsprechend mehr weitere ringförmige Kathoden-Elektrodenabschnitte.

Die Kathoden-Elektrode 42 dient zum einen der elektrischen Kontaktierung des n-dotierten vorderseitigen Emitters 30. Die Kathoden-Elektrode 42 hat jedoch grundsätzlich auch noch die zusätzliche Funktion Wärme, welche beim Fließen eines Stromes in dem Halbleiterbauelement entsteht, von dem Halbleiterkörper 100 wegzuleiten. Durch eine durchgehende Kathoden-Elektrode 42, wie sie beispielsweise in den Figuren 1 und 4 dargestellt ist, ergibt sich eine sehr homogene Wärmeableitung, da die gesamte Oberfläche des n-dotierten vorderseitigen Emitters 30 gleichmäßig kontaktiert wird. Wird die Kathoden-Elektrode 42 wie in Figur 9 dargestellt jedoch teilweise unterbrochen, werden solche Bereiche welche durch die resultierenden Kathoden-Elektrodenabschnitte direkt kontaktiert werden effektiver gekühlt als solche Bereiche des Halbleiterkörpers, welche sich unterhalb der einen oder mehreren Unterbrechungen befinden. Die Bereiche unterhalb der einen oder mehreren Unterbrechungen erhitzen sich somit stärker, was zu einer weiteren Verstärkung der Stromdichte in diesen Bereichen führt. Durch eine oder mehrere ringförmige Unterbrechungen der Kathoden-Elektrode 42 im Ausfallbereich 320 kann somit gezielt wenigstens ein "Hot Spot" erzeugt und der Ausfallbereich des Halbleiterbauelements gezielt eingestellt werden.

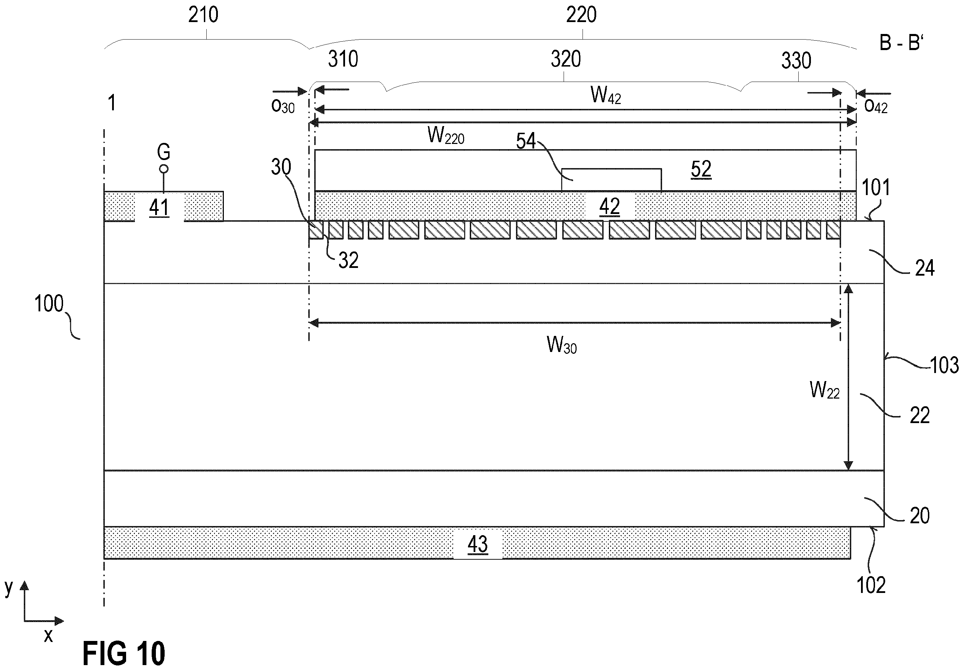

Ein solcher "Hot Spot" kann statt einer oder mehrerer Unterbrechungen der Kathoden-Elektrode 42 jedoch auch noch auf andere Art und Weise erzeugt werden. Bezug nehmend auf Figur 10, kann das Halbleiterbauelement weiterhin ein Gehäuse mit einem Gehäusedeckel 52 aufweisen. Dabei kann beispielsweise der gesamte Halbleiterkörper 100 von einem Gehäuse umgeben sein. In Figur 10 ist der Übersichtlichkeit halber nicht das gesamte Gehäuse, sondern lediglich ein Abschnitt des Gehäusedeckels 52 dargestellt. Der Gehäusedeckel 52 ist auf der Kathoden-Elektrode 42 angeordnet. Die Kathoden-Elektrode 42 kann beispielsweise durch den Gehäusedeckel 52 druckkontaktiert werden. Wärme die über die Kathoden-Elektrode 42 vom Halbleiterkörper 100 weggeleitet wird, kann weiter über den Gehäusedeckel 52 nach außen abgeführt werden. Anstatt eine oder mehrere Unterbrechungen in der Kathoden-Elektrode 42 vorzusehen, kann der Gehäusedeckel 52 innerhalb des Ausfallbereichs 320 eine Einkerbung oder Ausnehmung 54 aufweisen, so dass der Kontakt zwischen dem Gehäusedeckel 52 und der Kathoden-Elektrode 42 im Ausfallbereich 320 zumindest abschnittsweise unterbrochen ist. Der Effekt ist derselbe wie in Bezug auf Figur 9 beschrieben. Durch die Einkerbung 54 im Gehäusedeckel 52 wird Wärme in bestimmten Bereichen gezielt weniger effektiv abgeleitet, was wiederum in einer lokalen Erhöhung der Stromdichte im Halbleiterkörper 100 führt.

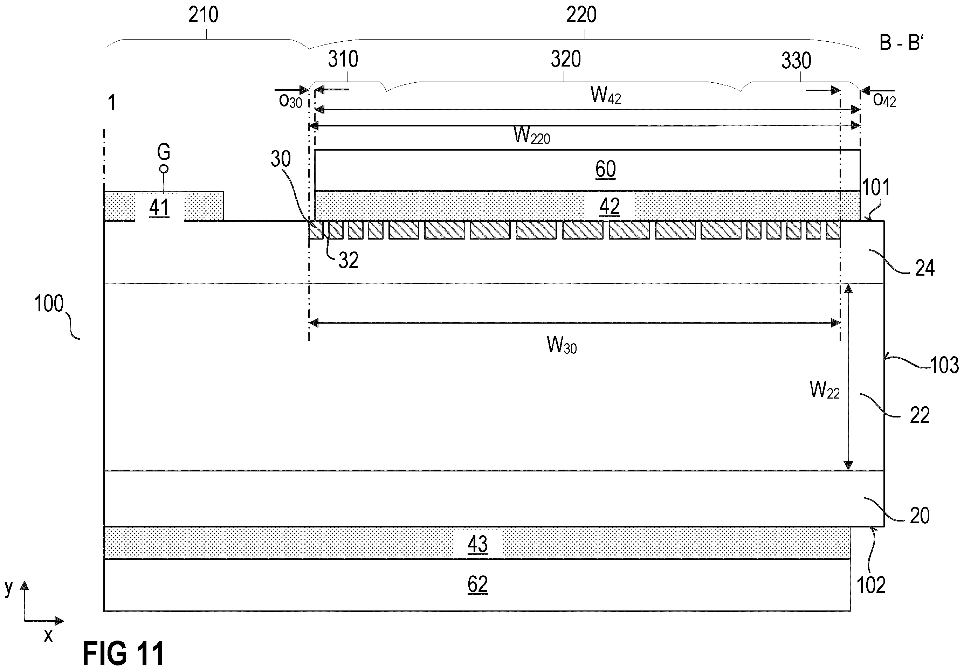

Nun Bezug nehmend auf Figur 11, kann das Halbleiterbauelement eine erste Kontaktscheibe 60, welche die Kathoden-Elektrode 42 elektrisch leitend kontaktiert, und eine zweite Kontaktscheibe 62 aufweisen, welche die Anoden-Elektrode 43 elektrisch kontaktiert. Die erste und die zweite Kontaktscheibe 60, 62 können beispielsweise zusammen mit dem Halbleiterkörper 100 innerhalb eines Gehäuses angeordnet sein. Die Kathoden-Elektrode 42 und die Anoden-Elektrode 43 können beispielsweise Aluminium aufweisen oder aus Aluminium bestehen. Der Gehäusedeckel 52 kann beispielsweise Kupfer aufweisen oder aus Kupfer bestehen. Die erste und die zweite Kontaktscheibe 60, 62 bestehen herkömmlicherweise meist aus Molybdän. Der thermische Ausdehnungskoeffizient von Molybdän liegt zwischen dem thermischen Ausdehnungskoeffizient von Kupfer und Silizium, aus welchem in der Regel der Halbleiterkörper 100 besteht. Daher sind aus Molybdän bestehende Kontaktscheiben 60, 62 in der Lage, hohe thermomechanische Kräfte, welche bei starker Lastwechselbeanspruchung des Halbleiterkörpers 100 entstehen, zu reduzieren.

Ein Thyristor-artiges Halbleiterbauelement, welches im Falle einer Störung einen auftretenden hohen Fehlerstrom abfängt und dadurch zerstört (aufgeschmolzen) wird, ist jedoch keiner Lastwechselbelastung ausgesetzt, so dass eine Reduzierung der thermo-mechanischen Kräfte mittels der Kontaktscheiben 60, 62 nicht erforderlich ist. Anstatt aus Molybdän, können die erste und/oder die zweite Kontaktscheiben 60, 62 daher aus anderen Materialien bestehen. Beispielsweise können die erste Kontaktscheibe 60 und/oder die zweite Kontaktscheibe 62 jeweils eine Kupferlegierung, eine Aluminiumlegierung, Kohlenstoff, oder ein Kohlenstoffverbundmaterial aufweisen oder umfassen. Die erste Kontaktscheibe 60 kann dabei das gleiche Material oder ein anderes Material umfassen als die zweite Kontaktscheibe 62. Beispielsweise kann die erste Kontaktscheibe 60 Kohlenstoff (z.B. Graphit) umfassen, während die zweite Kontaktscheibe 62 eine Aluminiumlegierung oder eine Kupferlegierung umfasst. Ebenso wäre es jedoch auch möglich, dass die erste Kontaktscheibe 60 eines von einer Kupferlegierung, einer Aluminiumlegierung, Kohlenstoff oder ein Kohlenstoffverbundmaterial umfasst, während die zweite Kontaktscheibe 62 eine herkömmliche Molybdän-Kontaktscheibe ist. Jegliche andere Kombinationen sind grundsätzlich möglich, wobei jedoch gemäß einer Ausführungsform wenigstens eine der Kontaktscheiben 60, 62 (in der Regel die erste Kontaktscheibe 60) aus einem anderen Material als Molybdän besteht.

Der Schmelzpunkt der beschriebenen Materialien (Kupferlegierung, Aluminiumlegierung, Kohlenstoff) kann gezielt eingestellt werden, wodurch der Aufschmelzvorgang beim Zünden des Halbleiterbauelements so optimiert wird, dass sich ein möglichst niederohmiger Kurzschluss zwischen dem Kathodenanschluss K und dem Anodenanschluss A ausbildet. Eine Kontaktscheibe 60, 62 aus einer Kupferlegierung oder aus einer Aluminiumlegierung kann während des Aufschmelzvorgangs sehr viel Energie aufnehmen und optimal mit dem Material des Halbleiterkörpers 100 (z.B. Silizium) legieren. Durch eine Kontaktscheibe 62 aus Kohlenstoff oder einem Kohlenstoffverbundmaterial kann eine Lichtbogenbildung (Ausbilden eines Plasmas) sogar gänzlich unterdrückt werden. Dadurch kann eine Plasmabildung in allen Bereichen des Halbleiterkörpers 100 reduziert oder sogar verhindert, und die Gefahr des ungewollten Austretens von Plasma aus dem Bauteil reduziert werden.

Alternativ oder zusätzlich ist es ebenfalls möglich, das Bauteil für sehr hohe Sperrspannungen auszulegen. Generell erhöht sich die Sperrspannung des Bauteils mit Erhöhung der Dicke des Halbleiterkörpers 100 in vertikaler Richtung y. Mit der Dicke des Halbleiterkörpers 100 erhöhen sich auch die Schaltverluste und die Durchlassverluste. Da ein Thyristor-artiges Halbleiterbauelement, welches im Falle einer Störung einen auftretenden hohen Fehlerstrom abfängt und dadurch zerstört (aufgeschmolzen) wird, jedoch keine Schaltvorgänge durchführt, spielen derart erhöhte Schalt- und Durchlassverluste keine wesentliche Rolle. Daher ist es möglich, die Dicke des Halbleiterkörpers 100 in vertikaler Richtung zu erhöhen, und dadurch die Sperrspannung des Bauteils zu erhöhen. Gemäß einem Beispiel weist der Halbleiterkörper 100 in vertikaler Richtung y eine Dicke von wenigstens 500μm und höchstens 1000μm, oder wenigstens 700μm und höchstens 1000μm auf. Dies resultiert beispielsweise in einer Sperrspannung von wenigstens 2,2kV bis zu 8kV. Eine noch größere Dicke des Halbleiterkörpers 100 von 1,5mm kann beispielsweise in einer Sperrspannung von um die 9kV resultieren. Eine weitere Erhöhung der Dicke des Halbleiterkörpers 100 führt grundsätzlich zu einer noch größeren Sperrspannung. Sperrspannungen von bis weit über 9kV sind durch eine weitere Erhöhung der Dicke des Halbleiterkörpers 100 grundsätzlich möglich. Die Dicke des Halbleiterkörpers 100 entspricht dabei einem Abstand zwischen der ersten Oberfläche 101 und der zweiten Oberfläche 102.

Durch die größere Dicke des Halbleiterkörpers 100 kann insbesondere das Sperrvermögen am Rand des Halbleiterkörpers 100 zur vertikalen Außenfläche 103 hin verbessert werden. Die Randbereiche des Halbleiterkörpers 100 zur vertikalen Außenfläche 103 hin sind bei größerer Dicke des Halbleiterkörpers 100 wesentlich robuster gegenüber möglicherweise auftretenden Überspannungen. Die Wahrscheinlichkeit eines Ausfalls des Bauteils in den Randbereichen wird gegenüber dünneren Halbleiterkörpers dadurch deutlich verringert. Es kann durch diese Maßnahme daher zusätzlich sichergestellt werden, dass ein Ausfall des Bauteils im Wesentlichen im Ausfallbereich 320 erfolgt. Das Risiko, dass Plasma aus dem Bauteil und möglicherweise sogar aus dem das Bauteil umgebenden Gehäuse austritt kann dadurch noch weiter verringert werden. Die Dicke des Halbleiterkörpers 100 kann jedoch so gewählt werden, dass sie einen bestimmten Maximalwert (z.B. 1000μm) nicht überschreitet. Bei Überschreiten einer bestimmten Dicke kann das Verhalten des Halbleiterbauelements jedoch möglicherweise nur noch schwer kontrollierbar sein.

**Patentansprüche**

1. Halbleiterbauelement mit:

einem Halbleiterkörper (100) der eine erste Oberfläche (101) und eine der ersten Oberfläche (101) in vertikaler Richtung (y) gegenüberliegende zweite Oberfläche (102), einen Gatebereich (210), und einen in horizontaler Richtung benachbart zu dem Gatebereich (210) angeordneten aktiven Bereich (220) aufweist;
einem ersten Emitter (20) eines ersten Leitungstyps (p, n), einer ersten Basis (22) eines zweiten Leitungstyps (n, p), und einer zweiten Basis (24) des ersten Leitungstyps (p, n) die zwischen der zweiten Oberfläche (102) und der ersten Oberfläche (101) in vertikaler Richtung (y) aufeinanderfolgend angeordnet sind;
einem in dem aktiven Bereich (220) angeordneten vorderseitigen Emitter (30) des zweiten Leitungstyps (n, p), der sich von der ersten Oberfläche (101) in vertikaler Richtung (y) in die zweite Basis (24) erstreckt; und
einer Vielzahl von Kurzschlussgebieten (32) des ersten Leitungstyps (p, n), die sich von der ersten Oberfläche (101) durch den vorderseitigen Emitter (30) hindurch bis zu der zweiten Basis (24) erstrecken, wobei
der aktive Bereich (220) einen an den Gatebereich (210) in horizontaler Richtung angrenzenden ersten Randbereich (310), einen an den ersten Randbereich (310) in horizontaler Richtung angrenzenden Ausfallbereich (320), und einen an den Ausfallbereich (320) in horizontaler Richtung angrenzenden zweiten Randbereich (330) aufweist, und
eine mittlere Dichte der in dem Ausfallbereich (320) angeordneten Kurzschlussgebiete (32) geringer ist als eine mittlere Dichte der jeweils in dem ersten Randbereich (310) und dem zweiten Randbereich (330) angeordneten Kurzschlussgebiete (32).

2. Halbleiterbauelement nach Anspruch 1, wobei eine Querschnittsfläche des Ausfallbereichs (320) in horizontaler Ebene zwischen 10% und 50% der Gesamtfläche des Halbleiterkörpers (100) beträgt.

3. Halbleiterbauelement nach Anspruch 1 oder 2, wobei jedes der Vielzahl von Kurzschlussgebieten (32) säulenartig ausgebildet ist und in horizontaler Richtung einen runden, ovalen oder mehreckigen Querschnitt aufweist.

4. Halbleiterbauelement nach Anspruch 3, wobei eine Ausdehnung jedes der Vielzahl von Kurzschlussgebieten (32) in horizontaler Richtung maximal 200μm beträgt.

5. Halbleiterbauelement nach Anspruch 3 oder 4, wobei

in dem ersten Randbereich (310) und dem zweiten Randbereich (330) der Abstand zwischen zwei direkt benachbarten Kurzschlussgebieten (32) zwischen 200$\mu$m und 800$\mu$m beträgt; und in dem Ausfallbereich (320) der Abstand zwischen zwei direkt benachbarten Kurzschlussgebieten (32) wenigstens 1000$\mu$m beträgt.

6. Halbleiterbauelement nach einem der Ansprüche 3 bis 5, wobei jedes der Vielzahl von Kurzschlussgebieten (32) in horizontaler Ebene eine identische Querschnittsfläche aufweist.

7. Halbleiterbauelement nach Anspruch 1 oder 2, wobei jedes der Vielzahl von Kurzschlussgebieten (32) ringförmig ausgebildet ist, so dass der vorderseitige Emitter (30) durch die Kurzschlussgebiete (32) in einzelne, konzentrische Ringe geteilt wird.

8. Halbleiterbauelement nach Anspruch 7, wobei eine Breite jedes der Vielzahl von Kurzschlussgebieten (32) in horizontaler Richtung maximal 200 $\mu$m oder maximal 500 $\mu$m beträgt.

9. Halbleiterbauelement nach Anspruch 7 oder 8, wobei

in dem ersten Randbereich (310) und dem zweiten Randbereich (330) der Abstand zwischen zwei direkt benachbarten Kurzschlussgebieten (32) zwischen 200$\mu$m und 800$\mu$m beträgt; und in dem Ausfallbereich (320) der Abstand zwischen zwei direkt benachbarten Kurzschlussgebieten (32) wenigstens 1000$\mu$m beträgt.

10. Halbleiterbauelement nach Anspruch 1 oder 2, wobei wenigstens eines der Vielzahl von Kurzschlussgebieten (32) ringförmig ausgebildet ist, und wenigstens eines der Vielzahl von Kurzschlussgebieten (32) säulenartig ausgebildet ist und in horizontaler Richtung einen runden, ovalen oder mehreckigen Querschnitt aufweist.

11. Halbleiterbauelement nach Anspruch 10, wobei wenigstens eines der in dem zweiten Randbereich (330) angeordneten Kurzschlussgebiete (32) ringförmig ausgebildet ist.

12. Halbleiterbauelement nach einem der vorhergehenden Ansprüche, der weiterhin aufweist:

eine im Gatebereich (210) auf der ersten Oberfläche (101) angeordnete und mit der zweiten Basis (24) elektrisch verbundene Gate-Elektrode (41);
eine im aktiven Bereich (220) auf der ersten Oberfläche (101) angeordnete und mit dem vorderseitigen Emitter (30) elektrisch verbundene Kathoden-Elektrode (42); und
eine auf der zweiten Oberfläche (102) angeordnete und mit dem ersten Emitter (20) elektrisch verbundene Anoden-Elektrode (43).

13. Halbleiterbauelement nach Anspruch 12, wobei die Kathoden-Elektrode (42) innerhalb des Ausfallbereichs (320) wenigstens eine ringförmige Unterbrechung aufweist.

14. Halbleiterbauelement nach Anspruch 12 oder 13, das weiterhin ein Gehäuse mit einem Gehäusedeckel (52) aufweist, wobei

der Gehäusedeckel (52) die Kathoden-Elektrode (42) kontaktiert, und
der Gehäusedeckel (52) innerhalb des Ausfallbereichs (320) eine Einkerbung (54) aufweist, so dass der Kontakt zwischen dem Gehäusedeckel (52) und der Kathoden-Elektrode (42) im Ausfallbereich (320) zumindest abschnittsweise unterbrochen ist.

15. Halbleiterbauelement nach einem der Ansprüche 12 bis 14, der weiterhin aufweist:

eine erste Kontaktscheibe (60), welche die Kathoden-Elektrode (42) elektrisch leitend kontaktiert; und
eine zweite Kontaktscheibe (62), welche die Anoden-Elektrode (43) elektrisch kontaktiert.

FIG 1

**FIG 2**

**FIG 3**

FIG 4

30

320

B

310

B'

330

100

Z

X

**FIG 5**

l_{32}

d_{32}

32

d_{32}

d_{32}

Z

X

**FIG 6**

**FIG 7**

**FIG 8**

FIG 9

EP 4 325 578 A1

FIG 10

EP 4 325 578 A1

FIG 11

Europäisches Patentamt
European Patent Office
Office européen des brevets

# EUROPÄISCHER RECHERCHENBERICHT

**Nummer der Anmeldung**

**EP 23 18 4963**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 9 741 839 B1 (NAKAGAWA TSUTOMU [US]) 22. August 2017 (2017-08-22) | 1-6,12 | INV. H01L29/06 |
| Y | * Fig. 1C mit zugehöriger Beschreibung * | 7-11,14, 15 | H01L29/08 H01L29/417 |
| A | | 13 | H01L29/74 |
| | ----- | | |
| X | US 4 281 336 A (SOMMER KARLHEINZ ET AL) 28. Juli 1981 (1981-07-28) | 1-6,12, 13 | |
| Y | * Spalte 4, Zeile 45 – Spalte 10, Zeile 68 * | 7-11,14, 15 | |
| | * Abbildungen 1-3 * | | |
| | ----- | | |
| Y | US 4 223 332 A (SITTIG ROLAND) 16. September 1980 (1980-09-16) * Spalte 2, Zeile 60 – Spalte 3, Zeile 19; Abbildungen 1,2 * | 7-11 | |
| | ----- | | |
| Y | EP 3 646 376 B1 (ABB POWER GRIDS SWITZERLAND AG [CH]) 16. September 2020 (2020-09-16) * Absatz [0043] – Absatz [0052]; Abbildung 2 * | 14,15 | RECHERCHIERTE SACHGEBIETE (IPC) |
| | ----- | | H01L |

Der vorliegende Recherchenbericht wurde für alle Patentansprüche erstellt

| Recherchenort | Abschlußdatum der Recherche | Prüfer |
|---|---|---|
| München | 10. Januar 2024 | Kostrzewa, Marek |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

...................................................................

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 23 18 4963

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

10-01-2024

| Im Recherchenbericht angeführtes Patentdokument | Datum der Veröffentlichung | Mitglied(er) der Patentfamilie | Datum der Veröffentlichung |
|---|---|---|---|
| US 9741839 B1 | 22-08-2017 | KEINE | |
| US 4281336 A | 28-07-1981 | DE 2917786 A1 | 13-11-1980 |
| | | GB 2050055 A | 31-12-1980 |
| | | US 4281336 A | 28-07-1981 |
| US 4223332 A | 16-09-1980 | CH 622127 A5 | 13-03-1981 |
| | | DE 2802599 A1 | 05-07-1979 |
| | | EP 0002840 A1 | 11-07-1979 |
| | | JP S5487487 A | 11-07-1979 |
| | | JP S6243548 B2 | 14-09-1987 |
| | | US 4223332 A | 16-09-1980 |
| EP 3646376 B1 | 16-09-2020 | CN 110892524 A | 17-03-2020 |
| | | EP 3646376 A1 | 06-05-2020 |
| | | JP 7232811 B2 | 03-03-2023 |
| | | JP 2020526931 A | 31-08-2020 |
| | | US 2020144141 A1 | 07-05-2020 |
| | | WO 2019011717 A1 | 17-01-2019 |

EPO FORM P0461

Für nähere Einzelheiten zu diesem Anhang : siehe Amtsblatt des Europäischen Patentamts, Nr.12/82